(19) Europäisches Patentamt
European Patent Office
Office européen des brevets

(11) **EP 2 787 643 A2**

(12) **EUROPÄISCHE PATENTANMELDUNG**

(43) Veröffentlichungstag:
**08.10.2014  Patentblatt 2014/41**

(51) Int Cl.:
***H03M 1/30*** *(2006.01)*     *H03M 3/00* *(2006.01)*

(21) Anmeldenummer: **14161891.8**

(22) Anmeldetag: **27.03.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **02.04.2013  DE 102013103273**

(71) Anmelder: **eesy-ic GmbH**
**90449 Nürnberg (DE)**

(72) Erfinder:
• **Ohnhäuser, Frank**
**90547 Stein (DE)**
• **Reinhold, Michael**
**91056 Erlangen (DE)**
• **Schmid, Konstantin**
**97762 Hammelburg (DE)**

(74) Vertreter: **Klinski, Robert et al**
**PATENTSHIP**
**Patentanwaltskanzlei**
**Elsenheimerstraße 65**
**80687 München (DE)**

(54) **Winkelbestimmer**

(57)    Die vorliegende Erfindung betrifft einen Winkelbestimmer (100) zum Bestimmen eines Winkels anhand eines ersten Phasensignals mit einer von dem Winkel abhängigen Phase und eines zweiten Phasensignals mit einer von dem Winkel abhängigen Phase, mit einer Delta-Sigma-Modulationseinrichtung (103-1, 103-2) zum Umsetzen des ersten Phasensignals in ein erstes digitales Signal und zum Umsetzen des zweiten Phasensignals in ein zweites digitales Signal und einer Signalverarbeitungseinrichtung (200) zum Bestimmen des Winkels aus dem ersten digitalen Signal und dem zweiten digitalen Signal.

Fig. 1

EP 2 787 643 A2

**Beschreibung**

Die vorliegende Erfindung betrifft einen Winkelbestimmer zum Bestimmen eines Winkels, eine Winkelbestimmeranordnung und ein Verfahren um Bestimmen eines Winkels.

Winkelbestimmer, auch Winkelgeber genannt, werden oft in elektrischen Motorsteueranwendungen verwendet, um die Winkelposition einer Welle des Motors zu bestimmen. Der Winkelbestimmer umfasst beispielsweise eine runde Scheibe aus durchsichtigem Glas mit äquidistanten intransparenten Streifen, die mit der Welle gekoppelt ist. Ein optischer Sensor des Winkelbestimmers zählt die transparenten Streifen, um eine aktuelle Winkelposition der Welle in Bezug auf eine Referenzmarkierung zu bestimmen.

In derartigen Anwendungen können Analog-Digital-Umsetzer (Analog-Digital-Converter - ADC) im Bereich typischer Eingabefrequenzen verwendet werden, die auf Sukzessiv-Approximationsregistern (Successive Approximation Register - SAR) basieren. Abtast- und Haltestufen-SAR-ADCs weisen typischerweise eine große Bandbreite auf. Rauschen und Störungen, die in die analogen Signale im Laufe der Signalübertragung von einem Sensor zu einer Auswerteschaltung eingekoppelt werden, beeinflussen und stören die Ausgangssignale. Eine differentielle Signalübertragung unterdrückt lediglich eine Gleichtaktstörung. Ein Hinzufügen von analogen Tiefpassfiltern erzeugt demgegenüber Signalverzögerungen, die einen bestimmten Winkel- oder Positionswert an einem bestimmten Zeitpunkt verfälschen.

Es ist eine Aufgabe der vorliegenden Erfindung, eine Auflösung eines Winkelbestimmers zu verbessern und ein Rauschen der Signale zu vermindern.

Diese Aufgabe wird durch Gegenstände nach den unabhängigen Ansprüchen gelöst. Weitere bevorzugte Ausführungsformen sind Gegenstand der abhängigen Ansprüche, der Beschreibung und der Figuren.

Gemäß einem ersten Aspekt betrifft die vorliegende Erfindung einen Winkelbestimmer zum Bestimmen eines Winkels anhand eines ersten Phasensignals mit einer von dem Winkel abhängigen Phase und eines zweiten Phasensignals mit einer von dem Winkel abhängigen Phase, mit einer Delta-Sigma-Modulationseinrichtung zum Umsetzen des ersten Phasensignals in ein erstes digitales Signal und zum Umsetzen des zweiten Phasensignals in ein zweites digitales Signal und einer Signalverarbeitungseinrichtung zum Bestimmen des Winkels aus dem ersten digitalen Signal und dem zweiten digitalen Signal. Mit diesem Winkelbestimmer wird der Vorteil erreicht, dass die Auflösung verbessert wird. Ein Rauschen kann zu höheren Frequenzen hin verschoben werden.

In einer vorteilhaften Ausführungsform des Winkelbestimmers umfasst die Signalverarbeitungseinrichtung ein Tiefpassfilter zum Tiefpassfiltern des ersten digitalen Signals oder des zweiten digitalen Signals. Der Ausgang des Tiefpassfilters kann als Eingang eines Signalzählers verwendet werden. Dadurch wird beispielsweise der technische Vorteil erreicht, dass hochfrequentes Rauschen aus den Signalen entfernt wird.

In einer weiteren vorteilhaften Ausführungsform des Winkelbestimmers umfasst der Winkelbestimmer einen Dezimator zum Verringern einer Dezimationsrate des ersten oder des zweiten digitalen Signals umfasst. Dadurch wird beispielsweise der technische Vorteil erreicht, dass eine verringerte Datenmenge erzeugt und eine Verarbeitung der Daten beschleunigt wird.

In einer weiteren vorteilhaften Ausführungsform des Winkelbestimmers umfasst die Delta-Sigma-Modulationseinrichtung einen Integrierer zum Integrieren des ersten oder des zweiten Phasensignals. Dadurch wird beispielsweise der technische Vorteil erreicht, dass das Signal über einen bestimmten Zeitraum addiert wird und sich ein Rauschen verringert.

In einer weiteren vorteilhaften Ausführungsform des Winkelbestimmers ist der Integrierer ein zeitkontinuierlicher Integrierer zum zeitkontinuierlichen Integrieren des ersten oder des zweiten Phasensignals. Dadurch wird beispielsweise der technische Vorteil erreicht, dass eine geringere Bandbreite benötigt wird und ein Rauschen und eine Leistungsaufnahme verringert werden.

In einer weiteren vorteilhaften Ausführungsform des Winkelbestimmers umfasst die Delta-Sigma-Modulationseinrichtung einen Rückkoppler zum Koppeln des ersten digitalen Signals mit dem ersten Phasensignal oder des zweiten digitalen Signals mit dem zweiten Phasensignal. Dadurch wird beispielsweise der technische Vorteil erreicht, dass eine Rauschformung durchgeführt wird.

In einer weiteren vorteilhaften Ausführungsform des Winkelbestimmers ist der Rückkoppler ein Mehrfach-Rückkoppler zum Rückkoppeln mehrerer Rückkopplungswerte mit dem ersten oder zweiten Phasensignal. Der Mehrfach-Rückkoppler ist beispielsweise ein Multibit-Rückkoppler. Dadurch wird beispielsweise der technische Vorteil erreicht, dass Integrationsfehler verringert werden.

In einer weiteren vorteilhaften Ausführungsform des Winkelbestimmers umfasst der Rückkoppler einen Digital-Analog-Stromumsetzer mit einem zeitkontinuierlichen Stromausgang. Dadurch wird beispielsweise der technische Vorteil erreicht, dass die Modulationseinrichtung einen kleineren Jitter aufweist und eine höhere Auflösung erreichen kann.

In einer weiteren vorteilhaften Ausführungsform des Winkelbestimmers ist die Delta-Sigma-Modulationseinrichtung ausgebildet, einen Strom zwischen einem positiven und einem negativen Eingang des Integrierers überlappend zu schalten. Durch die überlappende Umschaltung des Stromes zwischen einem positiven und einem negativen Integratoreingang des differentiell aufgebauten Modulators wird der technische Vorteil erreicht, dass ein kontinuierlicher Stromfluss und damit kleinste Störungen erreicht werden.

In einer weiteren vorteilhaften Ausführungsform des Winkelbestimmers umfasst der Rückkoppler eine dynamische Element-Anpassungseinheit zum Korrigieren von Versatzwerten. Der versatzkorrigierte Ausgang des Tiefpassfilters kann als Eingang eines Signalzählers verwendet werden. Dadurch wird beispielsweise der technische Vorteil erreicht, dass Versatzwerte korrigiert werden können und sich die Genauigkeit einer Winkelbestimmung erhöht.

In einer weiteren vorteilhaften Ausführungsform des Winkelbestimmers ist die Delta-Sigma-Modulationseinrichtung ausgebildet, das Common-Mode Eingangspotential zu regeln, so dass ein großer Common-Mode Eingangsbereich ermöglicht wird. Dadurch wird der technische Vorteil erreicht, dass das Gleichtaktpotenzial an dem Motor unterschiedlich zu der Abtast- und Steuerschaltung sein kann.

In einer weiteren vorteilhaften Ausführungsform des Winkelbestimmers umfasst der Winkelbestimmer einen RC-Takterzeuger zum Erzeugen eines Taktsignals und der RC-Takterzeuger und die Delta-Sigma-Modulationseinrichtung sind durch integrierte Schaltungen auf dem gleichen Chip gebildet. Dadurch wird beispielsweise der technische Vorteil erreicht, dass eine Zuführung eines externen Taktsignals unterbleiben kann und sich die Zeitkonstante des RC-Takterzeugers entsprechend der Zeitkonstanten des Integrierers ändert.

In einer weiteren vorteilhaften Ausführungsform des Winkelbestimmers umfasst die Delta-Sigma-Modulationseinrichtung einen Vergleicher zum Erzeugen des digitalen Signals durch

Vergleichen des ersten oder zweiten Phasensignals mit einem Referenzwert. Dadurch wird beispielsweise der technische Vorteil erreicht, dass ein Rückkopplungssignal auf einfache Weise erzeugt werden kann.

Gemäß einem zweiten Aspekt betrifft die vorliegende Erfindung eine Winkelbestimmeranordnung, mit einer rotierbaren Kodierscheibe mit einer Anzahl von Kodierungsmarkierungen; einem Sensor zur Erfassung einer Position eines drehbaren Gegenstandes, wobei der Sensor ausgebildet ist, ein erstes Phasensignal und ein zweites Phasensignal auszugeben, und dem Winkelbestimmer nach dem ersten Aspekt.

Mit der Winkelbestimmeranordnung nach dem zweiten Aspekt werden die gleichen technischen Vorteile wie durch den Winkelbestimmer nach dem ersten Aspekt erreicht.

In einer weiteren vorteilhaften Ausführungsform der Winkelbestimmeranordnung ist der Sensor ausgebildet, ein Stromsignal als das erste Phasensignal und das zweite Phasensignal auszugeben. Dadurch wird beispielsweise der technische Vorteil erreicht, dass eine Signalübertragung vereinfacht wird, da Ströme leichter als Spannungen übertragen werden können.

Gemäß einem dritten Aspekt betrifft die vorliegende Erfindung ein Verfahren zum Bestimmen eines Winkels anhand eines ersten Phasensignals mit einer von dem Winkel abhängigen Phase und eines zweiten Phasensignals mit einer von dem Winkel abhängigen Phase, mit den Schritten eines Umsetzens des ersten Phasensignals in ein erstes digitales Signal und eines Umsetzens des zweiten Phasensignals in ein zweites digitales Signal mittels einer Delta-Sigma-Modulationseinrichtung; und eines Bestimmens des Winkels aus dem ersten digitalen Signal und dem zweiten digitalen Signal. Mit den Verfahren nach dem dritten Aspekt werden die gleichen technischen Vorteile wie durch den Winkelbestimmer nach dem ersten Aspekt erreicht.

Die digitale Signalverarbeitungseinrichtung dient zum Bestimmen eines Drehwinkels mittels eines periodischen Eingabesignals und umfasst einen Tiefpassfilter zum Tiefpassfiltern des periodischen Eingabesignals; einen Phasenwinkelbestimmer zum Erfassen eines digitalen Phasenwinkelwertes auf Basis des tiefpassgefilterten Eingabesignals; einen Signalzähler zum Erfassen eines digitalen Periodenzählwertes; und ein Ausgaberegister zum Ausgeben des Drehwinkels auf Basis des digitalen Phasenwinkelwertes und des digitalen Periodenzählwertes.

Das Tiefpassfilter kann zur Filterung der Ausgabesignale eines Modulators verwendet werden, insbesondere eines Delta-Sigma-Modulators. Das periodische Eingabesignal kann ein Signalpaar mit einem ersten Eingabesignal, beispielsweise einem Sinus-Signal und einem zweiten Eingabesignal sein, beispielsweise einem Cosinus-Signal. Das Eingabesignal kann außerdem ein weiteres Signalpaar umfassen. Weiter kann das periodische Eingabesignal eine veränderliche Frequenz aufweisen. Der Signalzähler kann den digitalen Periodenzählwert auf Basis eines Periodensignals erfassen, beispielsweise auf Basis des tiefpassgefilterten Eingabesignals oder auf Basis eines von außen zur Signalverarbeitungseinrichtung zugeführten Periodensignals, beispielsweise durch Komparatoren.

Durch die digitale Signalverarbeitungseinrichtung wird beispielsweise der technische Vorteil erreicht, dass ein hochfrequentes Rauschen eines Modulators entfernt werden kann und sich die Genauigkeit einer Drehwinkelbestimmung verbessert. Der Phasenwinkel des Eingabesignals kann zur genauen Bestimmung des Drehwinkels herangezogen werden. Der genaue Drehwinkel wird auf Basis des digitalen Phasenwinkelwertes und des digitalen Periodenzählwertes in einem gemeinsamen Ausgaberegister abgelegt.

In einer vorteilhaften Ausführungsform der Signalverarbeitungseinrichtung ist das Tiefpassfilter ein Sinc-Filter. Dadurch wird beispielsweise der technische Vorteil erreicht, dass das Tiefpassfilter mit besonders niedrigem Hardwareaufwand realisierbar ist.

In einer weiteren vorteilhaften Ausführungsform der digitalen Signalverarbeitungseinrichtung umfasst das Tiefpassfilter einen Dezimator für das Eingabesignal von einem Delta-Sigma-Modulator. Dadurch wird beispielsweise der technische Vorteil erreicht, eine Datenrate verringert werden kann.

In einer weiteren vorteilhaften Ausführungsform der digitalen Signalverarbeitungseinrichtung umfasst die Signalverarbeitungseinrichtung eine Zeitkorrektureinrichtung zum Synchronisieren des digitalen Periodenzählwertes mit dem digitalen Phasenwinkelwert. Dadurch wird beispielsweise der technische Vorteil erreicht, dass eine Asynchronität eines von außen zur Signalverarbeitungseinrichtung zugeführten Periodensignals, beispielsweise eines Komparators, beseitigt werden kann.

In einer weiteren vorteilhaften Ausführungsform der digitalen Signalverarbeitungseinrichtung umfasst die Zeitkorrektureinrichtung eine Zustandsmaschine zum Berechnen eines Erwartungswertes für den Drehwinkel auf Basis einer Winkelgeschwindigkeit. Dadurch wird beispielsweise der technische Vorteil erreicht, dass ein einfach zu ermittelnder Wert für weitere Korrekturschritte verwendet werden kann.

In einer weiteren vorteilhaften Ausführungsform der digitalen Signalverarbeitungseinrichtung ist die Zeitkorrektureinrichtung ausgebildet, eine Winkelabweichung zwischen dem Erwartungswert für den Drehwinkel und einem bestimmten Drehwinkel zu berechnen. Dadurch wird beispielsweise der technische Vorteil erreicht, dass ein einfach zu handhabendes Maß zum Bestimmen eines Fehlers zwischen dem Phasenwinkelbestimmer und dem Signalzähler verwendet wird.

In einer weiteren vorteilhaften Ausführungsform der digitalen Signalverarbeitungseinrichtung ist die Zeitkorrektureinrichtung ausgebildet, den digitalen Periodenzählwert des Signalzählers herabzusetzen, falls die berechnete Winkelabweichung einen vorgegebenen Wert überschreitet oder ist die Zeitkorrektureinrichtung ausgebildet, den digitalen Periodenzählwert des Signalzählers heraufzusetzen, falls die berechnete Winkelabweichung einen vorgegebenen Wert unterschreitet. Dadurch wird beispielsweise der technische Vorteil erreicht, dass ein Fehler zwischen dem Phasenwinkelbestimmer und dem Signalzähler auf einfache Wiese beseitigt werden kann

In einer weiteren vorteilhaften Ausführungsform der digitalen Signalverarbeitungseinrichtung umfasst der Phasenwinkelbestimmer eine Versatzkorrektureinrichtung zum Korrigieren eines Versatzes des Eingabesignals. Dadurch wird beispielsweise der technische Vorteil erreicht, dass ein Versatzwert (Offsetwert) aus dem Eingangssignal beseitigt wird und sich die Signalqualität verbessert.

In einer weiteren vorteilhaften Ausführungsform der digitalen Signalverarbeitungseinrichtung umfasst die Signalverarbeitungseinrichtung einen Zeittriggereingang zum Zuführen eines Zeittriggersignals umfasst, um eine Winkelbestimmung auf eine externe Regelschleife zu synchronisieren. Dadurch wird beispielsweise der technische Vorteil erreicht, dass ein Gleichlauf der Signalverarbeitungseinrichtung erzielt wird.

In einer weiteren vorteilhaften Ausführungsform der digitalen Signalverarbeitungseinrichtung umfasst der Phasenwinkelbestimmer einen Zeitzähler zum Erfassen eines Zeitversatzes zwischen einer Aktualisierung des Tiefpassfilters und dem Zeittriggersignal. Der Zeitversatz ist beispielsweise der Zeitunterschied zwischen einer letzten Aktualisierung des Filters (Filterupdate) und einem externen Zeittriggersignal. Dadurch wird beispielsweise der technische Vorteil erreicht, dass der Zeitversatz auf besonders einfache Weise bestimmt werden kann.

In einer weiteren vorteilhaften Ausführungsform der digitalen Signalverarbeitungseinrichtung umfasst der Phasenwinkelbestimmer eine Extrapolationseinrichtung zum Extrapolieren des Phasenwinkelwerts auf Basis des erfassten Zeitversatzes und/oder einer Zeitverzögerung des digitalen Tiefpassfilters. Dadurch wird beispielsweise der technische Vorteil erreicht, dass ein voraussichtlicher Wert des Phasenwinkels bestimmt werden kann und ein Fehler aufgrund des Zeitversatzes zwischen der Aktualisierung des Tiefpassfilters und dem Zeittriggersignal beseitigt wird.

In einer weiteren vorteilhaften Ausführungsform der digitalen Signalverarbeitungseinrichtung umfasst der Phasenwinkelbestimmer eine Interpolationseinrichtung zum Interpolieren des Phasenwinkelwerts auf Basis des erfassten Zeitversatzes. Dadurch wird beispielsweise der technische Vorteil erreicht, dass sich Zwischenwerte des Phasenwinkels zur Zeit des Zeitversatzes bestimmen lassen und sich die Genauigkeit einer Winkelbestimmung erhöht.

In einer weiteren vorteilhaften Ausführungsform der digitalen Signalverarbeitungseinrichtung umfasst die Signalverarbeitungseinrichtung eine Frequenzerfassungseinrichtung zum Erfassen einer Frequenz des Eingabesignals auf Basis einer Veränderung des digitalen Zählwertes in einem vorgegebenen Zeitintervall. Dadurch wird beispielsweise der technische Vorteil erreicht, dass eine Frequenz zur Steuerung der Signalverarbeitungseinrichtung verwenden lässt.

In einer weiteren vorteilhaften Ausführungsform der digitalen Signalverarbeitungseinrichtung ist die Signalverarbeitungseinrichtung ausgebildet, eine Dezimationsrate dynamisch auf Basis der erfassten Frequenz zu ändern. Dadurch wird beispielsweise der technische Vorteil erreicht, dass die erfasste Frequenz als Grundlage für eine Steuerung der Dezimationsrate herangezogen werden kann, beispielsweise um eine Dezimationsrate bei Überschreiten einer vorgegebenen Frequenz zu verringern.

In einer weiteren vorteilhaften Ausführungsform der digitalen Signalverarbeitungseinrichtung umfasst der Phasenwinkelbestimmer ein Phasenregister zum Speichern des Phasenwinkelwertes. Dadurch wird beispielsweise der technische Vorteil erreicht, dass der Phasenwinkelwert als Grundlage für eine weitere digitale Verarbeitung zur Verfügung steht. In einer weiteren vorteilhaften Ausführungsform der digitalen Signalverarbeitungseinrichtung ist der Signalzähler ein bidirektionaler Signalzähler. Dadurch wird beispielsweise der technische Vorteil erreicht, dass sich sowohl ein zunehmender Drehwinkel als auch ein abnehmender Drehwinkel erfassen lassen.

In einer weiteren vorteilhaften Ausführungsform der Signalverarbeitungseinrichtung umfasst die Signalverarbeitungseinrichtung ein Positionsregister zum Speichern des korrigierten Zählwertes. Dadurch wird beispielsweise der technische Vorteil erreicht, dass der Zählwert gespeichert und weiterverarbeitet werden kann.

Ein Verfahren zum Bestimmen eines Drehwinkels mittels einer digitalen Signalverarbeitungseinrichtung anhand eines periodischen Eingabesignals umfasst die Schritte eines Tiefpassfilterns des periodischen Eingabesignals; eines Erfassens eines digitalen Phasenwinkelwertes auf Basis des tiefpassgefilterten Eingabesignals; eines Erfassens eines digitalen Periodenzählwertes; und eines Ausgebens des Drehwinkels auf Basis des digitalen Phasenwinkelwertes und des digitalen Periodenzählwertes. Die Digitalisierung kann mithilfe von Delta-Sigma-Modulatoren erfolgen. Durch das Verfahren zum Bestimmen eines Drehwinkels werden die gleichen Vorteile wie durch die digitale Signalverarbeitungseinrichtung nach dem ersten Aspekt erreicht.

Ausführungsbeispiele der Erfindung sind in den Zeichnungen dargestellt und werden im Folgenden näher beschrieben.

Es zeigen:

Fig. 1 einen schematischen Aufbau eines Winkelbestimmers;

Fig. 2 einen Signalverlauf des Winkelbestimmers;

Fig. 3 einen Delta-Sigma-Modulator einer ersten Ordnung;

Fig. 4 einen differentiellen zeitkontinuierlichen Delta-Sigma-Modulator mit Mehrfachbit-Rückkopplung, einer Strom-Digital-Analog-Umsetzung (DAC) und einer dynamischen Elementanpassung (DEM);

Fig. 5 die Schritte eines Verfahrens zum Bestimmen eines Winkels;

Fig. 6 eine schematische Ansicht einer Ausführungsform der Signalverarbeitungseinrichtung;

Fig. 6a eine schematische Ansicht einer weiteren Ausführungsform der Signalverarbeitungseinrichtung;

Fig. 6b eine schematische Ansicht einer weiteren Ausführungsform der Signalverarbeitungseinrichtung;

Fig. 6c eine schematische Ansicht einer weiteren Ausführungsform der Signalverarbeitungseinrichtung;

Fig. 7 eine Übersicht über das Verfahren zum Korrigieren eines Periodenzählwertes; und

Fig. 8 ein Verfahren zum Bestimmen eines Winkels.

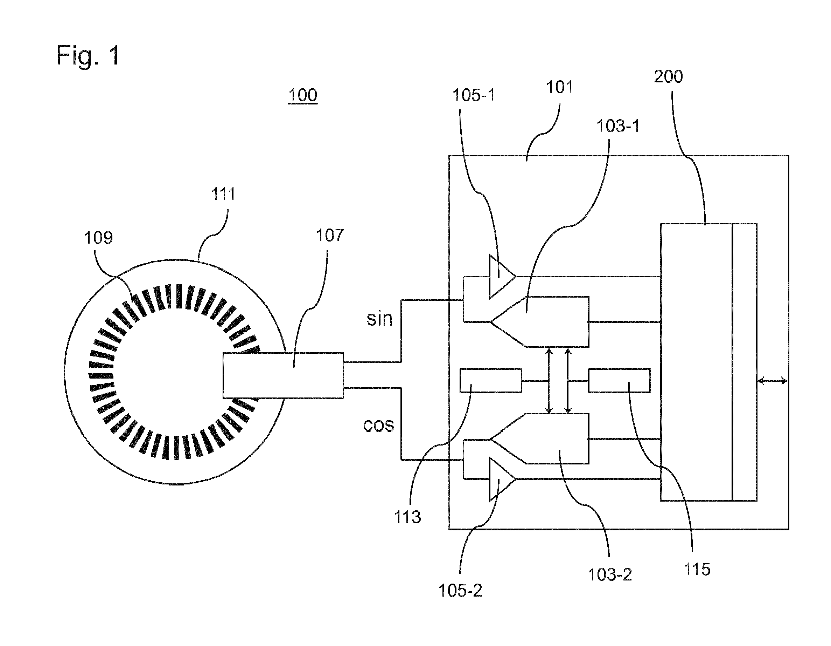

Fig. 1 zeigt einen schematischen Aufbau eines Winkelbestimmers 100 mit einer Auswerteschaltung 101 für die Signale eines optischen Sensors 107. Ein derartiger Winkelbestimmer 100 kann beispielsweise in elektrischen Motorsteueranwendungen verwendet werden, um die Winkelposition einer Welle eines Motors zu messen.

Eine Rundscheibe 111 aus durchsichtigem Glas mit äquidistanten intransparenten Streifen 109 ist beispielsweise auf der Welle des Motors montiert. Der optische Sensor 107 erfasst einen Lichtstrahl, der auf der gegenüberliegenden Seite der Rundscheibe 111 ausgesendet wird. Je nachdem ob der Lichtstahl auf den optischen Sensor 107 trifft oder von einem intransparenten Streifen 109 verdeckt wird, gibt der optische Sensor 107 ein unterschiedliches Signal aus.

Die Ausgabe des optischen Sensors 107 ist kein digitales Signal, sondern erscheint als ein analoges Sinuswellensignal, da ein einzelner, intransparenter Streifen 109 zunächst lediglich einen kleinen Teil des optischen Sensors 107 bedeckt, sich dann vollständig über den optischen Sensor 107 hinweg bewegt und dann wieder lediglich einen kleinen Teil des optischen Sensors 107 bedeckt, wenn dieser den optischen Sensor 107 verlässt. Somit werden von dem inkrementellen Kodierer analoge Sinus- und Cosinussignale ausgegeben. Werden diese Sinus- und Cosinussignale ausgewertet, kann die tatsächliche Winkelposition einer Welle bezüglich einer Referenzmarkierung bestimmt werden.

Durch Auswerten und Messen der Signalamplitude der Sinuswelle, kann die Auflösung des Winkelbestimmers 100 verbessert werden. Dies geschieht, indem aus der Signalamplitude der Sinuswelle ein Phasenwinkel des Signals berechnet wird, der zusätzliche Information darüber liefert, an welcher Winkelposition zwischen zwei der intransparenten Streifen 109 sich die Rundscheibe 111 befindet. Da eine Sinuswelle als solche für die Bestimmung einer Winkelposition nicht voll deterministisch ist, kann zusätzlich eine Cosinuswelle berücksichtigt werden.

Eine Auswerteschaltung 101 des Winkelbestimmers 100 wird durch eine zeitkontinuierliche Delta-Sigma-Analog-Digital-Umsetzerschaltung gebildet. Die Auswerteschaltung 101 umfasst zwei differentielle Vorzeichenvergleicher 105-1 und 105-2, auch Komparatoren genannt, sowie zwei zeitkontinuierliche Delta-Sigma-Modulatoren 103-1 und 103-2 als Analog-Digital-Umsetzer (ADC). Die Delta-Sigma-Modulatoren 103-1 und 103-2 bilden eine Delta-Sigma-Modulationseinrichtung.

Daneben umfasst die Auswerteschaltung 101 eine Referenzspannungsquelle 113 zum Zuführen einer Referenzspannung von beispielsweise 1,25 V und einen Takterzeuger 115 zum Erzeugen eines Takts mit einer Frequenz von beispielsweise 50 MHz. Zum weiteren Verarbeiten der Signale umfasst die Auswerteschaltung 101 eine digitale Signalverarbeitungseinrichtung 200 zum Bestimmen des Drehwinkels auf Grundlage der von den Delta-Sigma-Modulatoren 103-1 und 103-2 und Vorzeichenvergleichern 105-1 und 105-2 ausgegebenen Signale.

Die Auswertungsschaltung 101 zum Auswerten der Sinus- und der Cosinussignale kann entfernt gelegen installiert sein, so dass elektrische Kabel zum Übertragen der analogen Signale von dem optischen Sensor 107 zu der Auswertungsschaltung 101 verwendet werden. Diese Kabel können Gleichtaktspannungen (Common Mode Voltage - CM-Voltage), Versatzwerte und Hochfrequenzstörungen zu den analogen Signalen hinzufügen. Um eine Signalqualität aufrechtzuerhalten, können die Signale zwischen dem optischen Sensor 107 und der Auswerteschaltung 101 daher differentiell übertragen werden.

Zur Digitalisierung der Sinus- und der Cosinussignale können Analog-Digital-Umsetzer (Analog-Digital-Converter - ADC), die auf Sukzessiv-Approximationsregistern (Successive Approximation Register - SAR) basieren, bei den entsprechenden Signalfrequenzen verwendet werden. Abtast- und Haltestufen-SAR-ADCs weisen typischerweise eine große Bandbreite auf.

Rauschen und Störungen, die in die analogen Signale im Laufe der Signalübertragung von dem optischen Sensor 107 zu der Auswerteschaltung 101 mit dem Analog-Digital-Umsetzer eingekoppelt werden, können die Ausgabeergebnisse beeinflussen und stören. Eine differentielle Signalübertragung unterdrückt eine Gleichtaktstörung. Ein Hinzufügen von analogen Tiefpassfiltern kann Signalverzögerungen verursachen, die einen Positionswert zu einem bestimmten Zeitpunkt verfälschen.

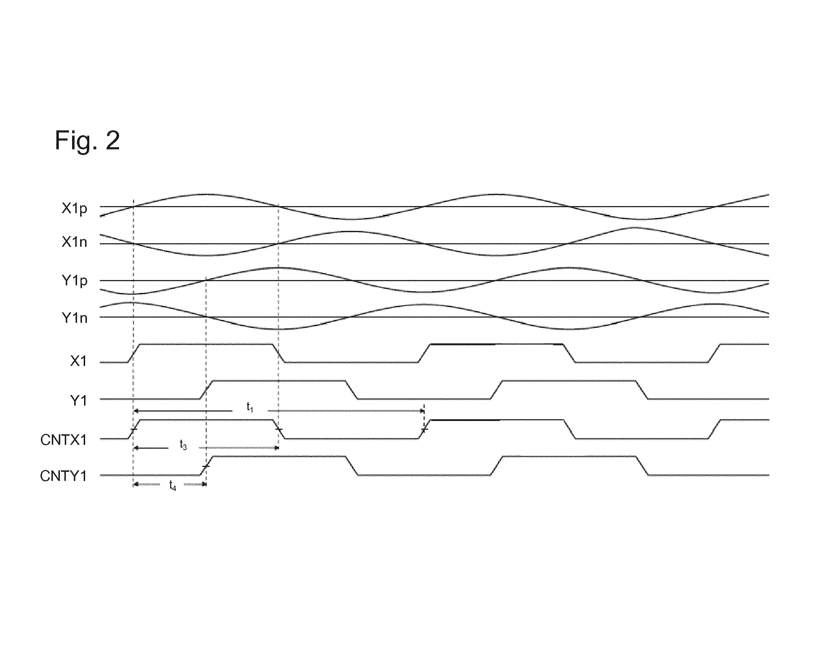

Fig. 2 zeigt einen Signalverlauf des optischen Sensors 107 und des Winkelbestimmers 100. Der optische Sensor 107 gibt als Signal eine Sinus- und eine Cosinuswelle aus, die differentiell an die Auswerteschaltung 101 übertragen werden.

Die Frequenz des Sinus- und Cosinussignals wird durch Multiplizieren der Anzahl an Streifen 109 auf der Rundschiebe 111 mit der Drehgeschwindigkeit der Rundscheibe 111 berechnet. Wenn sich die Welle des Motors mit einer Geschwindigkeit von 10.000 Umdrehungen pro Minute (1/6 kHz) dreht und die Anzahl der Streifen 109 auf der Rundscheibe 4096 beträgt ergibt sich eine Signalfrequenz von 682 kHz.

Die differentiellen Vorzeichenvergleicher 105-1 und 105-2 digitalisieren das vom optischen Sensor 107 bei einer Drehung der Scheibe ausgegebene Sinussignal X1 p und X1 n und das Cosinussignal Y1 p und Y1 n. Durch einen Vergleich der jeweiligen Eingabesignale werden durch die Vorzeichenvergleicher 105-1 und 105-2 die Signalverläufe X1 und Y1 erzeugt. Bei einem Vorzeichenwechsel oder Umkehr der Sinussignale X1 p und X1 n und Cosinussignale Y1 p und Y1n geben die Vorzeichenvergleicher 105-1 und 105-2 eine ansteigende oder absteigende Signalflanke als Periodensignal aus.

Die jeweiligen Signalflanken werden mit einem bidirektionalen Signalzähler gezählt, auch digitaler Auf-/Abzähler oder Up/Down Counter genannt. Der Zählwert des bidirektionalen Signalzählers spiegelt somit die Anzahl der Quadranten oder Oktanten des Signalverlaufs wieder, über die sich die Rundscheibe 111 hinwegbewegt hat. Teilt man beispielsweise die Anzahl der gezählten Quadranten durch 4 erhält man die Nummer des Streifens 109 an dem sich die Rundscheibe 111 befindet.

Bei der Drehung der Rundscheibe 111 über einen Streifen 109 hinweg wird der Signalzähler somit um einen Wert von 4 erhöht. Je nach Drehsinn der Rundscheibe 111 wird der bidirektionale Signalzähler erhöht oder erniedrigt. Der Winkel der Welle wird somit durch den Signalzähler auf der Basis des Sinussignals und des Cosinussignals mit einer Auflösung von einem Quadrant oder einem Oktant ausgewertet. Eine Änderung des Winkles wird durch eine inkrementelle Änderung in dem Zustand des Sinussignals oder Cosinussignals überwacht.

Falls der Winkelbestimmer 100 eine Rundscheibe 111 mit 4096 (12 Bit) intransparenten Streifen 109 aufweist und die vier Quadranten des Sinus- und Cosinussignals (2 Bit) berücksichtigt werden, kann folglich eine Gesamtauflösung von 14 Bit durch die differentiellen Vorzeichenvergleicher 105-1 und 105-2 erzielt werden.

Die Delta-Sigma-Modulatoren 103-1 und 103-2 tasten zusätzlich das ausgegebene Sinussignal X1 p und X1 n und das Cosinussignal Y1 p und Y1 n ab und wandeln dieses in digitale Werte um. Durch ein Teilen des ermittelten Sinuswerts durch den Cosinuswert wird ein Tangenswert erhalten. Durch Anwenden einer Arkustangens-Funktion auf den Tangenswert in der Signalverarbeitungseinrichtung 200 kann der Phasenwinkel des Sinusund Cosinussignals bestimmt werden. Der Phasenwinkel spiegelt die exakte Lage der Rundscheibe 111 zwischen zwei intransparenten Streifen 109 wider. Durch ein zusätzliches Bestimmen des Phasenwinkels kann dann die Auflösung des Winkelbestimmers 100 erhöht werden.

Statt einer Arkustangens-Funktion kann auch eine Arkuskotangens-Funktion verwendet werden, da die Arkustangensfunktion lediglich in einem bestimmten Bereich definiert ist. In diesem Fall kann ein modifizierter Zähler verwendet werden.

Falls Delta-Sigma-Modulatoren 103-1 und 103-2 als Analog-Digital-Umsetzer (ADC) mit einer Auflösung von 12-Bit verwendet werden, kann die zuvor erwähnte Auflösung von 14 Bit um weitere 12 Bit erhöht werden. Kombiniert man also die Anzahl der gezählten Quadranten mit dem Phasenwinkel, der durch die Delta-Sigma-Modulatoren 103-1 und 103-2 bestimmt wird, resultiert eine extrem hohe Winkelauflösung von 26 Bit.

Zu diesem Zweck werden die Ergebnisse der Vorzeichenvergleicher 105-1 und 105-2 und der Delta-Sigma-Modulatoren 103-1 und 103-2 in der Signalverarbeitungseinrichtung 200 gefiltert und weiterverarbeitet. Anschließend wertet beispielsweise ein Motorsteuersystem die Motorposition zu einem bestimmten Zeitpunkt in der Motorsteuerschleife aus.

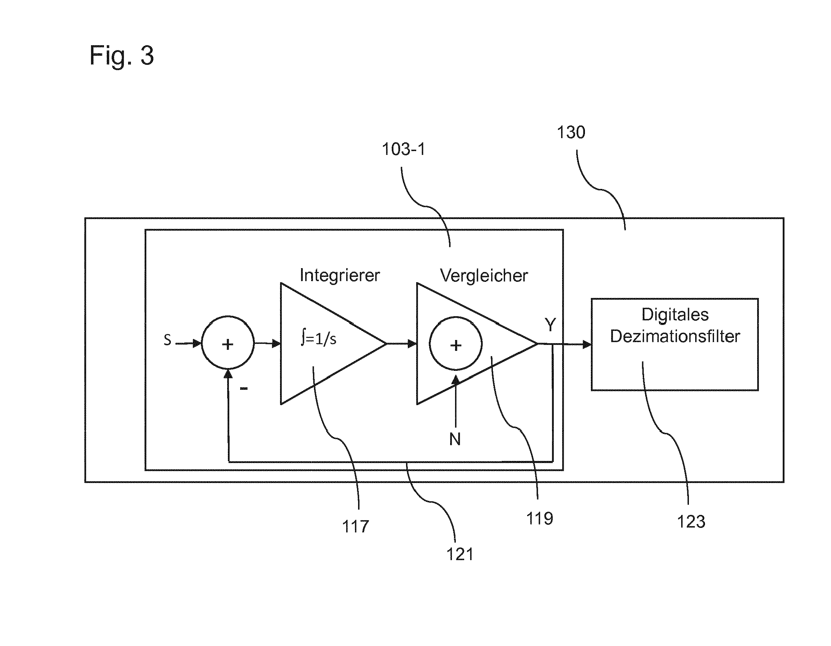

Fig. 3 zeigt einen Delta-Sigma-Modulator 103-1 erster Ordnung zum Umsetzen eines analogen Signals in ein digitales Signal. Der Delta-Sigma-Modulator 103-1 umfasst einen Integrierer 117 zum Integrieren des analogen Signals S, einen Vergleicher 119 zum Erzeugen eines digitalen Signals durch Vergleichen des integrierten analogen Signals mit einem Referenzwert und einen Rückkoppler 121 zum Koppeln des digitalen Signals mit dem analogen Signal. Zusätzlich umfasst der Delta-Sigma-Umsetzer 130 einen Dezimator 123 zum Verringern einer Abtastrate des digitalen Ausgabesignals.

Es ist ein Vorteil von Analog-Digital-Umsetzern, die auf einer Delta-Sigma-Modulation basieren, dass diese in der Lage sind, Rauschen effizient zu unterdrücken. Die Ausgabe des Delta-Sigma-Modulators 103-1 kann durch Formel 1 berechnet werden,

$$Y = S\frac{1}{1+s} + N\frac{s}{1+s} \tag{1}$$

wobei S das analoge eingegebene Signal ist, N das Quantisierungsrauschen ist und Y das digitale ausgegebene Signal ist, das in Form eines kontinuierlichen Bitstroms vorliegt. Der Bitstrom kann ein Strom aus Digitalwörtern einer niedrigen Auflösung sein, wie beispielsweise 4 Bit. Analog-Digital-Umsetzer mit mehreren Bits werden Modulatoren mit Mehrfachbit-Rückkopplung genannt.

Der Delta-Sigma-Modulator 103-1 wirkt als ein Tiefpassfilter für das eingegebene Signal und ein Hochpassfilter für Quantisierungsrauschen. Der Bitstrom wird digital tiefpassgefiltert, so dass ein Hochfrequenzrauschen unterdrückt wird. Dieses Verfahren wird Rauschformen (Noise Shaping) genannt und kann durch Hinzufügen von mehreren Integrierern 117 verstärkt werden. Jeder Integrierer 117 erzeugt eine Phasenverschiebung und beeinflusst die Stabilität der Rückkopplungsschleife.

Eine kontinuierliche Integration und ein Überabtasten (Oversampling) des Delta-Sigma-Modulators 103-1 unterdrücken das Hochfrequenzrauschen und erhöhen die Genauigkeit des digitalisierten Signals.

Um die erforderliche Eingabebandbreite zu erreichen, können zeitkontinuierliche (Continuous-Time - CT) Delta-Sigma-Modulatoren statt Umsetzern mit geschalteten Kondensatoren (Switched Capacitor - SC) verwendet werden, bei denen die eingegebene Spannung während einer ersten Taktphase abgetastet wird und in einer zweiten Taktphase integriert wird.

Schaltungen mit geschalteten Kondensatoren erfordern oft Verstärker mit einer großen Bandbreite. Zeitkontinuierliche Lösungen integrieren hingegen kontinuierlich und erfordern eine geringere Bandbreite der Verstärker in den Integrierern 117 und erzeugen ein geringeres Rauschen und eine geringere Leistungsaufnahme. Ein weiterer Vorteil des zeitkontinuierlichen (CT) Delta-Sigma-Modulators 103-1 ist ein konstanter Eingangswiderstand. Mit der zeitkontinuierlichen Umsetzung ist es daher möglich, eine hohe Eingangsbandbreite für Delta-Sigma-Modulatoren mit einer hohen Leistungsfähigkeit zu erreichen.

Allerdings kann in zeitkontinuierlichen Analog-Digital-Umsetzern ein Taktrauschen die Rauschleistung beeinflussen. Um diesen Effekt zu verringern, kann ein Mehrfachbit-Rückkoppler verwendet werden, so dass der integrierte Fehler (S-Y) kleiner ist.

Der Rückkoppler 121 kann als ein kontinuierlicher Strom-Digital-Analog-Umsetzer (DAC) statt einem Schalten von Spannungen implementiert sein. Wie bei stromlenkenden Digital-Analog-Umsetzern (Current Steering DACs) ist eine Diskontinuität während des Schalteffektes geringer. Die Diskontinuität kann die Rauschleistung in ähnlicher Weise wie Taktrauschen beeinflussen. Um die Effekte der Diskontinuität zu verringern, kann der Rückkopplungsstrom mit überlappenden Taktsignalen geschaltet werden.

Der Rückkoppler 121 ist mit dem Eingang verbunden. Dabei wird das digitalisierte Signal erneut in ein analoges Signal umgesetzt. Eine Nichtlinearität in der Rückkopplungsschleife wird direkt in einer Nichtlinearität des Analog-Digital-Umsetzers widergespiegelt. Zusätzlich kann der Rückkoppler 121 mit einer dynamischen Elementanpassung (Dynamic Element Matching - DEM) implementiert sein.

Ein intern geregelter Gleichtaktstrom (Common Mode Current - CM Current) kann zu dem positiven und dem negativen Eingang hinzugefügt werden, um große Gleichtakteingangsbereiche zuzulassen. Dies ist technisch vorteilhaft, da das Gleichtaktpotenzial an dem Motor unterschiedlich zu der Abtast- und Steuerschaltung sein kann. Die integrierte Schaltung (Integrated Circuit - IC) kann weitere analoge Elemente umfassen, wie beispielsweise Vorzeichenvergleicher (Komparatoren) oder Fenstervergleicher (Fensterkomparatoren) sowie digitale Komponenten.

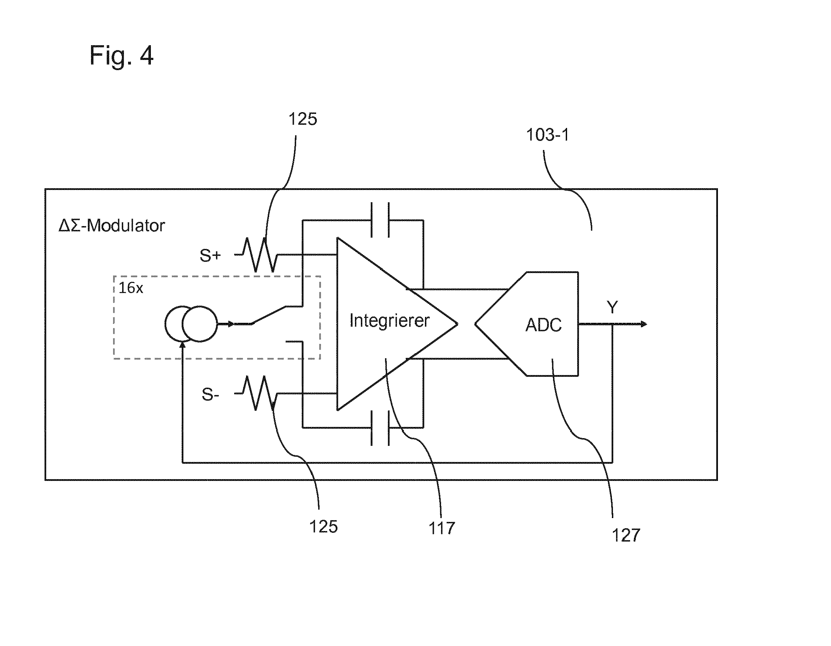

Fig. 4 zeigt einen zeitkontinuierlichen Delta-Sigma-Modulator 103-1 mit Mehrfachbit-Rückkopplung, Strom-Digital-Analog-Umsetzung (DAC) und einer dynamischen Elementanpassung (DEM), bei dem die differentiellen Eingänge mit Eingangswiderständen 125 verbunden sind. Ein (Mehrfachbit-)Analog-Digital-Umsetzer 127 wird statt einem Vergleicher 105 verwendet. Ein Rückkopplungs-Digital-Analog-Umsetzer (Strom-DAC) verwendet sechzehn Stromquellen mit einer dynamischen Elementanpassung (DEM).

Ein RC-Takterzeuger kann zu der integrierten Schaltung IC hinzugefügt werden. Widerstände und Kondensatoren können bis zu $\pm 20\%$ variieren, falls diese während eines Halbleiterprozesses integriert werden. Dies beeinflusst direkt die Zeitkonstante des Integrierers 117. Der Integrierer 117 sättigt in diesem Fall entweder, wenn die Zeitkonstante zu klein ist, oder die Integrierer-Ausgangsspannung wird nicht voll ausgenutzt. Der RC-Takterzeuger kann auf dem gleichen Siliziumchip (IC) wie der Modulator 103-1 integriert sein.

Falls ein RC-Takterzeuger in der gleichen integrierten Schaltung integriert ist, ändert sich die Zeitkonstante des RC-Takterzeugers entsprechend der Zeitkonstante des Integrierers 117 und stellt eine optimale Verwendung des Spannungsbereiches des Integrierers 117 sicher. Der beschriebene Analog-Digitalumsetzer 103-1 kann in dritter Ordnung mit einer Rückkopplung von 4 Bit implementiert und der Signalpfad kann voll differentiell sein.

Die differentiellen Eingänge S+ und S- können als Stromeingänge verwendet werden, falls die Eingangswiderstände 125 entfernt werden. Der Winkelbestimmer 100 kann mit einem Stromausgang statt einem Spannungsausgang implementiert sein, da Ströme leichter als Spannungen übertragen werden können.

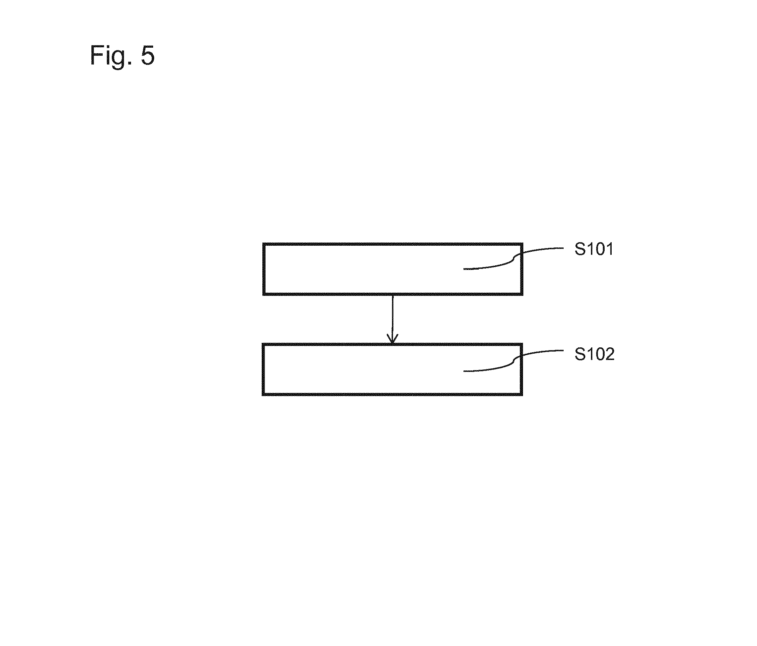

Fig. 5 zeigt die Schritte des Verfahrens zum Bestimmen eines Winkels anhand eines ersten Phasensignals mit einer von dem Winkel abhängigen Phase und eines zweiten Phasensignals mit einer von dem Winkel abhängigen Phase. Das Verfahren umfasst die Schritte S101 eines Umsetzens des ersten Phasensignals in ein erstes digitales Signal und eines Umsetzens des zweiten Phasensignals in ein zweites digitales Signal mittels einer Delta-Sigma-Modulationseinrichtung 103-1 oder 103-2. Als weiterer Schritt S102 umfasst das Verfahren ein Bestimmen des Winkels aus dem ersten digitalen Signal und dem zweiten digitalen Signal.

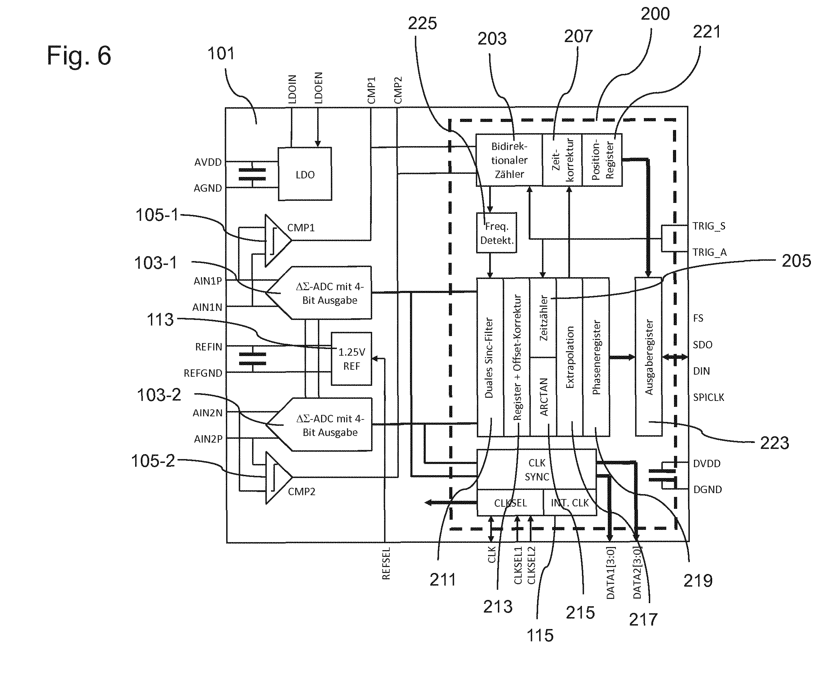

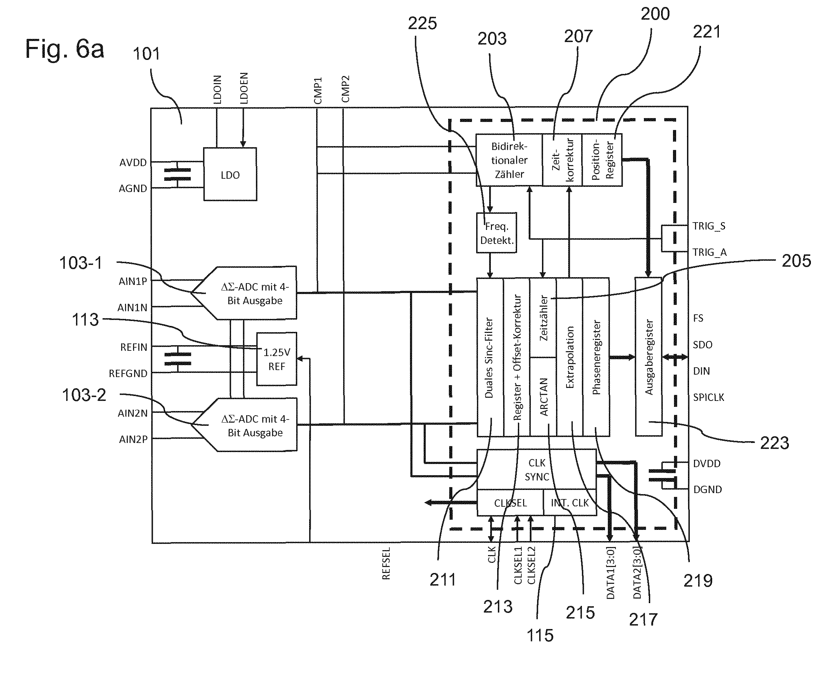

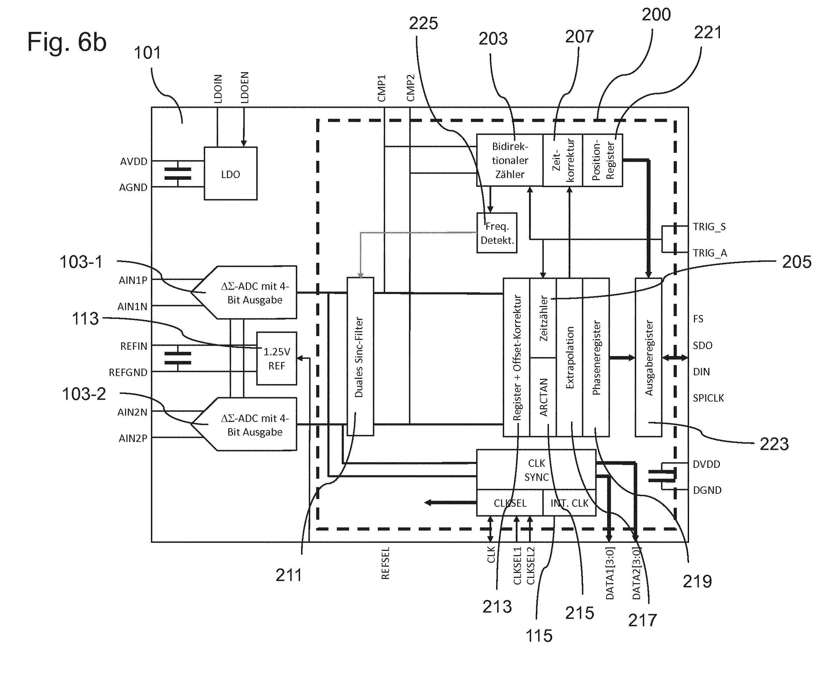

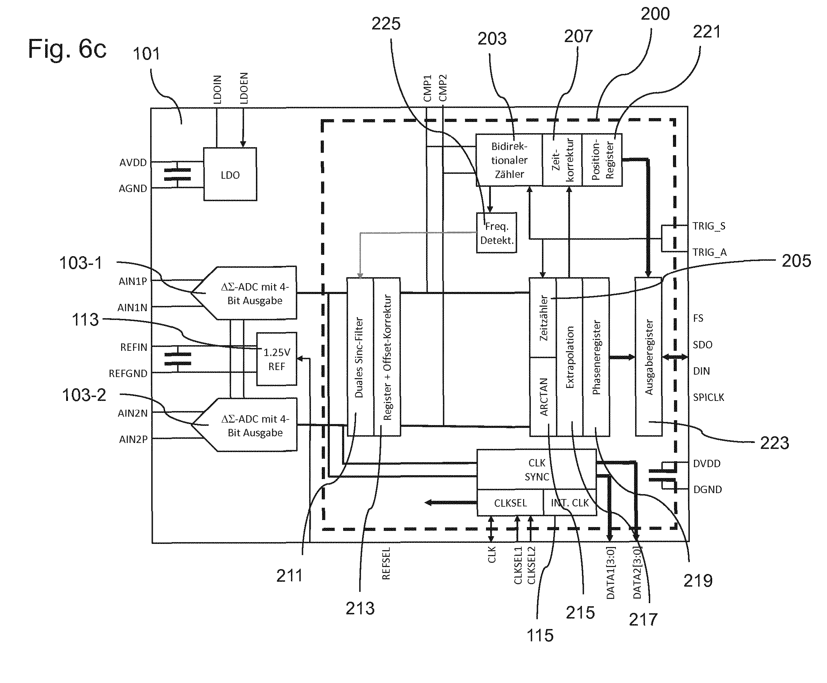

Fig. 6 zeigt eine schematische Ansicht einer Ausführungsform einer Signalverarbeitungseinrichtung 200 der Auswerteschaltung 101. In der Signalverarbeitungseinrichtung 200 wird anhand der Signale, die von den Vorzeichenvergleichern 105-1 und 105-2 und den Delta-Sigma-Modulatoren 103-1 und 103-2 erzeugt werden, der Drehwinkel der Rundscheibe 111 bestimmt. Zu diesem Zweck wird die Information von den Vorzeichenvergleichern 105-1 und 105-2 und den Delta-Sigma-Modulatoren 103-1 und 103-2 in der Signalverarbeitungseinrichtung ausgewertet, verarbeitet und kombiniert.

Ein bidirektionaler Signalzähler 203 innerhalb der Signalverarbeitungseinrichtung 200 zählt die Signalflanken, die von den Vorzeichenvergleichern 105-1 und 105-2 als Periodensignal ausgegeben werden, sowohl in aufsteigender Richtung als auch in absteigender Richtung. Allerdings können die Vorzeichenvergleicher 105-1 und 105-2 und die Delta-Sigma-Modulatoren 103-1 und 103-2 eine unterschiedliche Signalverzögerung aufweisen. In diesem Fall kommen die von den Vorzeichenvergleichern 105-1 und 105-2 ausgegebenen Periodensignale und die von den Delta-Sigma-Modulatoren 103-1 und 103-2 ausgegebenen Eingabesignale zu unterschiedlichen Zeiten an der Signalverarbeitungseinrichtung 200 an.

Eine fehlende Synchronisation zwischen den Vorzeichenvergleichern 105-1 und 105-2 und Delta-Sigma-Modulatoren 103-1 und 103-2 kann daher dazu führen, dass ein Wert des Signalzählers 203 fälschlicherweise um 1 im Vergleich zur Sinus-/Cosinusinformation versetzt ist. Daher umfasst die Signalverarbeitungseinrichtung 200 eine Zeitkorrektureinrichtung 207 zum Synchronisieren eines digitalen Periodenzählwertes mit dem digitalen Phasenwinkelwert. Zur Plausibilitätsprüfung berechnet eine Zustandsmaschine einen Erwartungswert für den Drehwinkel auf Basis einer zuvor gemessenen Winkelgeschwindigkeit. Die Zeitkorrektureinrichtung 207 berechnet eine Winkelabweichung zwischen dem Erwartungswert für den Drehwinkel und einem tatsächlich bestimmten Drehwinkel. Anschließend wird der korrigierte Drehwinkel in einem Positionsregister 221 gespeichert.

Überschreitet die berechnete Winkelabweichung einen vorgegebenen Wert, wird der digitale Periodenzählwert des Signalzählers 203 herabgesetzt. Unterschreitet die berechnete Winkelabweichung einen vorgegebenen Wert, wird der digitale Periodenzählwert des Signalzählers 203 heraufgesetzt. Der Zählwert des Signalzählers 203 wird somit durch die Zeitkorrektureinrichtung 207 auf Basis eines Erwartungswertes korrigiert, so dass der Fehler aufgrund einer Asynchronität der von den Vorzeichenvergleichern 105-1 und 105-2 ausgegebenen Periodensignale und der von den Delta-Sigma-Modulatoren 103-1 und 103-2 ausgegebenen Eingabesignale korrigiert wird.

Beispielsweise liefert der Signalzähler einen digitalen Periodenzählwert von 011 und die Extrapolationseinrichtung 217 liefert einen digitalen Phasenwinkelwert von 111101, der um eine Verzögerung des Zeitzählers 205 und des Tiefpassfilters 211 korrigiert ist. Das Ergebnis im Ausgaberegister 223 wäre ein Drehwinkel von 011-111101. Der Erwartungswert unter Berücksichtigung einer Winkelgeschwindigkeit ist 011-000011. In diesem Fall wird vermutet, dass durch einen Zeitversatz zwischen dem von den Vorzeichenvergleichern 105-1 und 105-2 ausgegebenen Periodensignalen und den von den Delta-Sigma-Modulatoren 103-1 und 103-2 ausgegebenen Eingabesignalen der Signalzähler 203 zu früh von 010 auf 011 gesprungen ist und die Extrapolationseinrichtung 217 noch nachläuft. In diesem Fall wird der Signalzähler 203 auf 010 herabgesetzt und das Ergebnis im Ausgaberegister 223 ist 010-111101.

Die Zeitkorrektureinrichtung 207 kann allerdings durch eine dynamische Änderung der Drehgeschwindigkeit beeinflusst werden. Aus diesem Grund kann die Zeit zwischen zwei Zählwerten (Anzahl von Taktzyklen) überwacht werden und Änderungen in einer Drehgeschwindigkeit bei der Berechnung des Erwartungswertes berücksichtigt werden.

Sowohl zum Signalzähler 203 als auch zum Zeitzähler 205 werden zwei Triggersignale zugeführt, nämlich ein synchrones Triggersignal TRIG_S als Filtersteuerung und ein asynchrones Triggersignal TRIG_A als Referenz. Für das synchrone und asynchrone Triggersignal können Register vorgesehen sein. Somit existieren zwei Triggersignale, nämlich ein erstes, das mit der normalen Regelschleife synchron ausgelöst wird, und ein zweites, das an einer Referenzmarke den Winkel bestimmt.

Weiter umfasst die Signalverarbeitungseinrichtung 200 ein Tiefpassfilter 211 für die Ausgabesignale der Delta-Sigma-Modulatoren 103-1 und 103-2, das Frequenzkomponenten oberhalb einer vorgegebenen Bandbreite entfernt und Daten bei einer festen Datenrate ausgibt, wie beispielsweise ein Sinc-Filter. Die vom Tiefpassfilter 211 ausgegebenen Daten werden in einem Register gespeichert und durch eine Versatzkorrektureinrichtung 213 um einen Versatzfehler (Offset) korrigiert, beispielsweise durch Addieren oder Subtrahieren eines konstanten Wertes.

Zusätzlich kann eine nicht gezeigte Verstärkungskorrektureinrichtung vorgesehen sein, um Verstärkungsfehler zu korrigieren. Diese Verstärkungsfehler werden oft durch die IC-interne Referenz verursacht, so dass Sinus- und Cosinussignale gleichermaßen betroffen sind.

Die gefilterten und durch die Versatzkorrektureinrichtung 213 korrigierten Sinus- und Cosinuswerte werden dann verwendet, um durch einen Phasenwinkelbestimmer 215 den diskreten und digitalen Phasenwinkelwert der Eingabesignale zu berechnen. Dazu wird zunächst aus den gefilterten und korrigierten Sinus- und Cosinuswerten ein Tangenswert berechnet. Unter Anwendung einer Arkustangensfunktion auf den Tangenswert und einer Nachschlagetabelle wird der Phasenwinkel des Signals erhalten.

Dieser Phasenwinkel wird durch eine Extrapolationseinrichtung 217 auf Basis eines Zeitversatzes extrapoliert, da die feste Datenrate des Tiefpassfilters 211 asynchron zu den Triggersignalen sein kann. Der Zeitversatz wird von dem Zeitzähler 205 erfasst, der die Zeit zwischen einer Aktualisierung des Tiefpassfilters 211 und einem Triggersignal misst. Das Ergebnis der Extrapolation wird in einem Phasenwinkelregister 219 gespeichert.

Bei einer hohen Drehgeschwindigkeit der Rundscheibe 111 weisen die Signale, die von dem optischen Sensor 107 ausgegeben werden, eine hohe Frequenz auf, beispielsweise von mehr als 100 kHz. In diesem Fall kann durch die Verzögerung des Tiefpassfilters 211 und die Extrapolation ein Fehler verursacht werden. Die Signalverarbeitungseinrichtung 200 umfasst daher eine Frequenzerfassungseinrichtung 225, die die Frequenz der Signale durch Überwachen des Signalzählers 203 über ein vorgegebenes Zeitintervall bestimmt.

Stellt die Frequenzerfassungseinrichtung 225 fest, dass eine Frequenz der Eingangssignale eine bestimmte vorgegebene Schwelle überschreitet, beispielsweise 100 kHz, wird die Ausgabe der Frequenzerfassungseinrichtung 225 an das Tiefpassfilter 211 weitergeleitet und ein Überabtastungsverhältnis (Oversampling Ratio - OSR) oder eine Dezimationsrate entsprechend verringert. Dadurch kann eine Filterverzögerung verringert werden.

Die so gewonnenen Daten können dann mit einem Ausgaberegister 223 als digitale Schnittstelle übertragen werden, beispielsweise einer seriellen Peripherie-Schnittstelle - SPI-Schnittstelle. Die digitale Schnittstelle kann eine Dateneingabe (Data Input - DIN) zum externen Steuern der zuvor erläuterten Funktionen umfassen. Insbesondere können einzelne Funktionen, wie beispielsweise die Extrapolation der Extrapolationseinrichtung 217, deaktiviert werden, so dass Rohdaten übertragen werden. Weitere Korrekturen und Berechnungen anhand der Rohdaten können durch eine externe Steuerschaltung durchgeführt werden.

Fig. 6a zeigt eine schematische Ansicht einer weiteren Ausführungsform der Signalverarbeitungseinrichtung 200, in der die gleichen Bezugszeichen wie in Fig. 6 verwendet werden. Der Delta-Sigma-Analog-Digital-Umsetzer (ADC) 103-1 und 103-2 mit einem Multibit-Ausgang liefert eine kontinuierliche Vorzeicheninformation in Form des höchstwertigen Bits (Most Significant Bit - MSB) als Periodensignal für den Signalzähler 203. Dieses Periodensignal wird dem bidirektionalen Signalzähler 203 von außerhalb der Signalverarbeitungseinrichtung 200 zugeführt. In diesem Fall kann eine Hysterese eingebaut werden, die beispielsweise mit digitalen Gattern realisiert werden kann. Diese Hysterese kann beispielsweise im bidirektionalen Signalzähler 203 integriert sein. Dadurch kann der Vorzeichenvergleicher wegfallen, wodurch der technische Vorteil erreicht wird, dass der Hardwareaufwand und die Verlustleistung verringert werden.

Fig. 6b zeigt eine schematische Ansicht einer weiteren Ausführungsform der Signalverarbeitungseinrichtung 200, in der die gleichen Bezugszeichen wie in Fig. 6 verwendet werden. In dieser Ausführungsform liefert der Ausgang des Filters 211 aus dem tiefpassgefilterten Eingabesignal kontinuierlich eine Vorzeicheninformation in Form des höchstwertigen Bits (MSB) als Periodensignal für den Signalzähler 203. In diesem Fall kann ebenfalls eine Hysterese eingebaut werden, die beispielsweise im Filter 211 eingebaut ist, da hier eine hohe Auflösung vorliegt. Durch ein Entfernen des analogen Vorzeichenvergleichers wird der technische Vorteil erreicht, dass der Hardwareaufwand und die Verlustleistung werden und mit dem Abgriff nach dem Filter 211 eine Zeitverzögerung und eine Zeitkorrektur entfallen.

Fig. 6c zeigt eine schematische Ansicht einer weiteren Ausführungsform der Signalverarbeitungseinrichtung 200, in der die gleichen Bezugszeichen wie in Fig. 6 verwendet werden. In dieser Ausführungsform wird der versatzkorrigierte Filterwert aus dem tiefpassgefilterten Eingabesignal für die Vorzeicheninformation in Form des höchstwertigen Bits (MSB) als Periodensignal herangezogen. Dadurch wird beispielsweise zusätzlich der technische Vorteil erreicht, dass die Vorzeicheninformation eine höhere Genauigkeit aufweist.

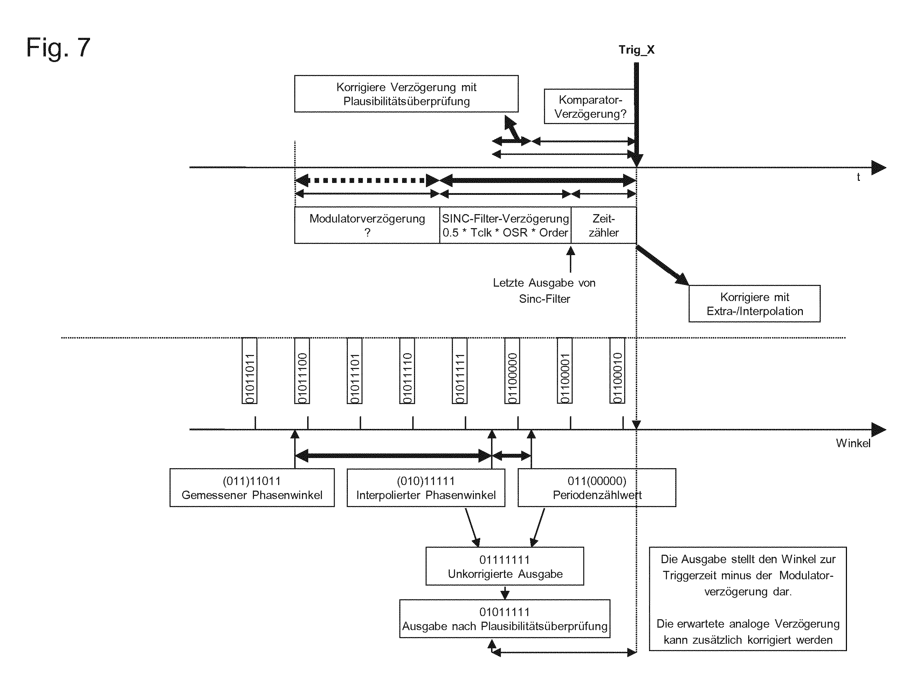

Fig. 7 zeigt eine Übersicht über das Verfahren zum Korrigieren eines Periodenzählwertes und einen zeitlichen Verlauf.

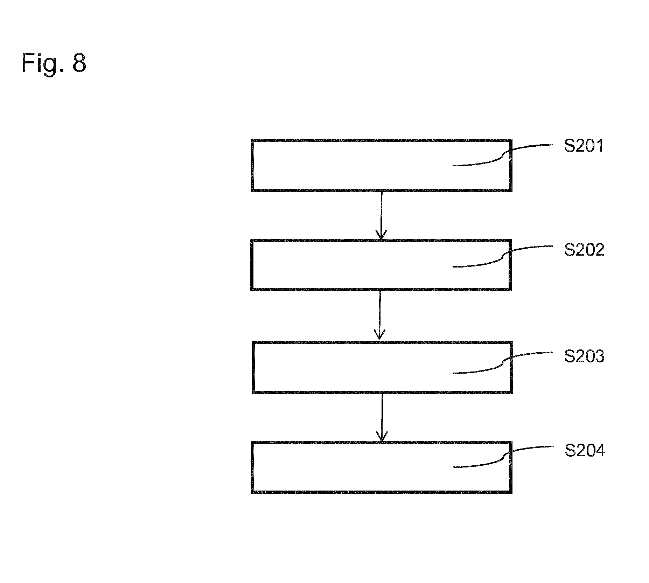

Fig. 8 zeigt ein Verfahren zum Bestimmen eines Drehwinkels mittels einer digitalen Signalverarbeitungseinrichtung 200 anhand eines periodischen Eingabesignals, mit dem Schritt S201 eines Tiefpassfilterns des periodischen Eingabesignals, dem Schritt S202 eines Erfassen eines digitalen Phasenwinkelwertes auf Basis des tiefpassgefilterten Eingabesignals; dem Schritt S203 eines Erfassen eines digitalen Periodenzählwertes; und dem Schritt S204 eines Ausgebens des Drehwinkels auf Basis des digitalen Phasenwinkelwertes und des digitalen Periodenzählwertes.

Alle Merkmale, die in Bezug auf einzelne Ausführungsformen der Erfindung erläutert oder gezeigt worden sind, können in jeglicher Kombination vorgesehen sein, um ihre vorteilhaften Effekte gleichzeitig zu realisieren.

Der Umfang der Erfindung wird durch die Patentansprüche definiert und ist nicht durch die Merkmale beschränkt, die in der Beschreibung erläutert werden oder in den Figuren gezeigt sind.


BEZUGSZEICHENLISTE


| 100 | Winkelbestimmer |
|---|---|
| 101 | Auswerteschaltung |
| 103-1 | Delta-Sigma-Modulator |
| 103-2 | Delta-Sigma-Modulator |
| 105-1 | Vorzeichenvergleicher |
| 105-2 | Vorzeichenvergleicher |
| 107 | optischer Sensor |
| 109 | Streifen |
| 111 | Rundscheibe |
| 113 | Referenzspannungsquelle |
| 115 | Takterzeuger |
| 117 | Integrierer |
| 119 | Vergleicher |
| 121 | Rückkoppler |
| 123 | Tiefpassfilter und Dezimator |
| 125 | Eingangswiderstand |
| 127 | Analog-Digital-Umsetzer |
| 130 | Delta-Sigma Umsetzer |
| 200 | Signalverarbeitungseinrichtung |
| 203 | Signalzähler |
| 205 | Zeitzähler |
| 207 | Zeitkorrektureinrichtung |
| 211 | Tiefpassfilter/Filter |
| 213 | Versatzkorrektureinrichtung |
| 215 | Phasenwinkelbestimmer |
| 217 | Extrapolationseinrichtung |
| 219 | Phasenregister |
| 221 | Positionsregister |
| 223 | Ausgaberegister |
| 225 | Frequenzerfassungseinrichtung |
| S101 - S102 | Verfahrensschritte |
| S201 - S204 | Verfahrensschritte |


**Patentansprüche**

**1.** Winkelbestimmer (100) zum Bestimmen eines Winkels anhand eines ersten Phasensignals mit einer von dem Winkel abhängigen Phase und eines zweiten Phasensignals mit einer von dem Winkel abhängigen Phase, mit:

einer Delta-Sigma-Modulationseinrichtung (103-1, 103-2) zum Umsetzen des ersten Phasensignals in ein erstes digitales Signal und zum Umsetzen des zweiten Phasensignals in ein zweites digitales Signal; einer digitalen Signalverarbeitungseinrichtung (200) zum Bestimmen des Winkels aus dem ersten digitalen Signal und dem zweiten digitalen Signal.

2. Winkelbestimmer (100) nach Anspruch 1, wobei die Signalverarbeitungseinrichtung (200) ein Tiefpassfilter zum Tiefpassfiltern des ersten digitalen Signals und/oder des zweiten digitalen Signals umfasst.

3. Winkelbestimmer (100) nach einem der vorangehenden Ansprüche, wobei der Winkelbestimmer (100) einen Dezimator (123) zum Verringern einer Abtastrate des ersten und/oder des zweiten digitalen Signals umfasst.

4. Winkelbestimmer (100) nach einem der vorangehenden Ansprüche, wobei die Delta-Sigma-Modulationseinrichtung (103-1, 103-2) einen Integrierer (117) zum Integrieren des ersten und/oder des zweiten Phasensignals umfasst.

5. Winkelbestimmer (100) nach Anspruch 4, wobei der Integrierer (117) ein zeitkontinuierlicher Integrierer zum zeitkontinuierlichen Integrieren des ersten und/oder des zweiten Phasensignals ist.

6. Winkelbestimmer (100) nach einem der vorangehenden Ansprüche, wobei die Delta-Sigma-Modulationseinrichtung (103-1, 103-2) einen Rückkoppler (121) zum Koppeln des ersten digitalen Signals mit dem ersten Phasensignal oder des zweiten digitalen Signals mit dem zweiten Phasensignal umfasst.

7. Winkelbestimmer (100) nach Anspruch 6, wobei der Rückkoppler (121) ein Mehrfach-Rückkoppler zum Rückkoppeln mehrerer Rückkopplungswerte mit dem ersten oder zweiten Phasensignal ist.

8. Winkelbestimmer (100) nach Anspruch 6 oder 7, wobei der Rückkoppler (121) einen Digital-Analog-Stromumsetzer mit einem zeitkontinuierlichen Stromausgang umfasst.

9. Winkelbestimmer (100) nach einem der vorangehenden Ansprüche, wobei die Delta-Sigma-Modulationseinrichtung (103-1, 103-2) ausgebildet ist, einen Strom zwischen einem positiven und einem negativen Eingang des Integrierers (117) überlappend zu schalten.

10. Winkelbestimmer (100) nach einem der Ansprüche 6 bis 9, wobei der Rückkoppler (121) eine dynamische Element-Anpassungseinheit zum Korrigieren von Versatzwerten umfasst.

11. Winkelbestimmer (100) nach einem der vorangehenden Ansprüche, wobei die Delta-Sigma-Modulationseinrichtung (103-1, 103-2) ausgebildet ist, das Common-Mode Eingangspotential zu regeln, so dass ein großer Common-Mode Eingangsbereich ermöglicht wird.

12. Winkelbestimmer (100) nach Anspruch 11, wobei der Winkelbestimmer (100) einen RC-Takterzeuger zum Erzeugen eines Taktsignals umfasst und der RC-Takterzeuger und die Delta-Sigma-Modulationseinrichtung (103-1, 103-2) durch integrierte Schaltungen auf dem gleichen Chip gebildet sind.

13. Winkelbestimmeranordnung, mit:

einer rotierbaren Kodierscheibe (111) mit einer Anzahl von Kodierungsmarkierungen (109); einem Sensor (107) zur Erfassung einer Position eines drehbaren Gegenstandes, wobei der Sensor (107) ausgebildet ist, ein erstes Phasensignal und ein zweites Phasensignal auszugeben, und dem Winkelbestimmer (100) nach einem der Ansprüche 1 bis 12.

14. Winkelbestimmeranordnung nach Anspruch 13, wobei der Sensor (107) ausgebildet ist, ein Stromsignal als das erste Phasensignal und das zweite Phasensignal auszugeben.

15. Verfahren zum Bestimmen eines Winkels anhand eines ersten Phasensignals mit einer von dem Winkel abhängigen Phase und eines zweiten Phasensignals mit einer von dem Winkel abhängigen Phase, mit den Schritten:

Umsetzen (S101) des ersten Phasensignals in ein erstes digitales Signal und Umsetzen des zweiten Phasensignals in ein zweites digitales Signal mittels einer Delta-Sigma-Modulationseinrichtung (103-1, 103-2); und Bestimmen (S102) des Winkels aus dem ersten digitalen Signal und dem zweiten digitalen Signal.

Fig. 1

EP 2 787 643 A2

# Fig. 2

Fig. 3

Integrierer     Vergleicher

$\int = 1/s$

Digitales
Dezimationsfilter

103-1

130

117

121

119

123

S

Y

N

EP 2 787 643 A2

Fig. 4

ΔΣ-Modulator

103-1

Integrierer

ADC

Y

S+

S-

125

125

117

127

16x

Fig. 5

Fig. 6

Fig. 6a

EP 2 787 643 A2

Fig. 6b

EP 2 787 643 A2

Fig. 6c

# Fig. 7

**Trig_X**

Korrigiere Verzögerung mit
Plausibilitätsüberprüfung

Komparator-
Verzögerung?

t

| Modulatorverzögerung ? | SINC-Filter-Verzögerung 0.5 * Tclk * OSR * Order | Zeit-zähler |
|---|---|---|

Letzte Ausgabe von
Sinc-Filter

Korrigiere mit
Extra-/Interpolation

01011011  01011100  01011101  01011110  01011111  01100000  01100001  01100010

Winkel

| (011)11011 Gemessener Phasenwinkel | (010)11111 Interpolierter Phasenwinkel | 011(00000) Periodenzählwert |
|---|---|---|

01111111
Unkorrigierte Ausgabe

01011111
Ausgabe nach Plausibilitätsüberprüfung

Die Ausgabe stellt den Winkel zur
Triggerzeit minus der Modulatorverzögerung dar.

Die erwartete analoge Verzögerung
kann zusätzlich korrigiert werden

EP 2 787 643 A2

22

Fig. 8

EP 2 787 643 A2

S201

S202

S203

S204